Europäisches Patentamt

European Patent Office

Office européen des brevets

(11) Publication number:

**0 399 704**
**A2**

# EUROPEAN PATENT APPLICATION

(21) Application number: **90305090.4**

(22) Date of filing: **11.05.90**

(51) Int. Cl.⁵: **G01R 23/165**

(30) Priority: **24.05.89 GB 8911914**

(43) Date of publication of application:
**28.11.90 Bulletin 90/48**

(84) Designated Contracting States:
**DE FR**

(71) Applicant: **MARCONI INSTRUMENTS LIMITED**
**Longacres Hatfield Road**
**St. Albans Hertfordshire, AL4 0JN(GB)**

(72) Inventor: **Thomas, Neil Edwin**
**29 Salisbury Avenue**
**St. Albans, Hertfordshire, AL1 4UB(GB)**

(74) Representative: **Hoste, Colin Francis**
**The General Electric Company p.l.c. Central**
**Patent Department (Wembley Office) Hirst**
**Research Centre East Lane**
**Wembley Middlesex, HA9 7PP(GB)**

(54) **Frequency spectrum determination using interpolation.**

(57) Apparatus, e.g. a spectrum analyser or frequency counter, for determining the frequency and/or amplitude of a spectral line in the frequency spectrum of an input signal, comprising a window-defining filter for shaping and truncating the input signal amplitude as a function of time, means for applying a discrete Fourier transform to the filtered input signal to store representations of signal amplitude at each of several predetermined, contiguous frequency bins, and means for interpolating between the stored values of signal amplitude to determine the frequency and/or amplitude of an amplitude peak in the input signal, wherein the interpolation means fits the stored values to a Gaussian or near-Gaussian curve which is close to the Fourier transform of the window function defined by the filter.

EP 0 399 704 A2

## Frequency Spectrum Determination Using Interpolation

This invention relates to apparatus for and to a method of determining, to an improved accuracy, the frequency or amplitude (or both) of a spectral line in the frequency spectrum of an input signal, and is particularly useful in electronic spectrum analysers and frequency counters.

In conventional spectrum analysers, a data processor performs a fast Fourier transformation (FFT) of digital data representing samples of the input signal amplitude, to produce data representing estimates of the signal amplitude in each of several discrete frequency "bins". Consequently the best resolution obtainable for the frequency of an input signal is the fineness of the frequencies at which estimates are made, i.e. the width of a bin. As the frequency resolution is equal to the reciprocal of the length of the time record, very long records need to be processed to get good frequency resolution, e.g. 10ms of data to get 100Hz resolution.

As a further consequence of the discreteness of the estimates, if an input signal has a frequency slightly different from the centre frequency of a bin, the amplitude estimate of that signal will be in error. The amplitude estimate for a constant amplitude of signal varies from being correct when in the centre of the bin, to being smaller at either extreme edge of the bin. This effect is termed "scollop loss".

The data samples are passed through a data window, i.e. a filter for shaping and truncating the input signal, before undergoing the fast Fourier transform process.

In the case of a rectangular data window, the scollop loss is 3.92dB at the edge of the bin. In practice, the rectangular window is never used other than in special situations, and a window tapering from typically zero at the ends to a maximum in the middle is used. Though not used primarily to affect the scollop loss, tapering windows do improve scollop loss, reducing it to typically 1dB.

1dB is still far too much error for the majority of applications. For these uses, so called flat-top windows have been developed. They reduce scollop loss to typically 0.1dB. In optimising the window for good scollop loss, inevitably other parameters of the window such as main lobe width and sidelobe level suffer. These windows are not good general purpose windows, but specially reserved for where better amplitude accuracy is required. While 0.1dB is good enough for many applications, it is not good enough for precision measurements.

Many workers have attempted to interpolate the results of the Fourier transform to obtain the true position of the peak of a spectral line. The interpolation curve is applied to the magnitude of the voltage spectrum. The usual first attempt is to use the peak point in the actual data and its two neighbours to define a parabola, i.e. to use second order interpolation. Low order interpolation is th simplest to do, and uses the least number of data points. Using the least number of data points is not simply for economy : the further away from the peak that one includes data, the more likely the estimate is to be corrupted by signals close by. The use of this interpolation method never produces results better than a flat-top window. Higher order interpolation schemes work a little better in ideal cases, but with more complexity, and with vulnerability to close-in signals.

There are two methods, equivalent in accuracy, different in execution, for correctly interpolating the peaks of spectra. The first is called zero padding. If a short length data record is taken, and padded with zeroes to, say, four times its original length, the resulting transform will have $\frac{1}{4}$ of the bin spacing. The peak position of the signal may then be read to $\frac{1}{4}$ of the unpadded frequency resolution, and the peak amplitude of the signal read to much better accuracy. This extra resolution is sometimes termed empty resolution; while the technique does correctly interpolate the points of the original transform, no more detail will be shown, as no more data than the original sequence was taken. The drawbacks of this technique, the requirement for a very long FFT to accommodate the extra zeroes, and the only limited improvement to the frequency resolution, mean that this technique is rarely used.

The alternative method to interpolate the original data points is to evaluate the chirp-Z transform on a small arc of the unit circle in the Z plane which includes the frequency peak of interest. This technique allows ideal interpolation, with FFTs no longer than the original data, but requires several FFT evaluations to evaluate the chirp-Z transform. Again, as the input data record is still the same length, the extra resolution is empty resolution. The chirp-Z does allow essentially perfect amplitude estimation, and much better frequency estimation than the above method, in exchange for complexity and running time.

Accordingly, the invention provides apparatus for determining the frequency and/or amplitude of a spectral line in the frequency spectrum of an input signal, comprising a window-defining filter for shaping and truncating the input signal amplitude as a function of time, means for applying a discrete Fourier transform to the filtered input signal to store representations of signal amplitude at each of several predetermined, contiguous frequency bins, and means for interpolating between the stored values of signal amplitude to determine the frequency and/or amplitude of an amplitude peak in the input signal, wherein the interpolation means fits the stored values to a Gaussian or near-Gaussian curve which is close to the Fourier transform of the window function defined by the filter.

In another aspect, the invention provides a method of determining the frequency and/or amplitude of a spectral line in the frequency spectrum of an input signal, comprising shaping and truncating the input signal in accordance with a predetermined data window, applying a discrete Fourier transform to the shaped input signal to derive and store representations of signal amplitude at each of several predetermined, contiguous frequency bins, and interpolating between the stored values of signal amplitude to determine the said frequency and/or amplitude, by fitting the stored values to a Gaussian or near-Gaussian curve which is close to the Fourier transform of the data window.

In this interpolation technique, which takes advantage of the shape of a typical spectral line peak being approximately Gaussian, the interpolation curve is matched to the data window. They may match very closely (a first example); or the window may be chosen and the interpolation curve approximated so as to optimise the accuracy of peak position determination (second example); or the interpolation curve may be chosen and the window approximated for optimisation (third example).

Thus, in the first example, the window-defining filter effects a Gaussian shape, and the interpolation means preferably fits the stored values to a Gaussian curve. For the second and third examples, the window-defining filter consists of a Blackman-Harris window. In the case of the second example, the interpolation means fits the stored values to a near-Gaussian curve whose parameters are determined such as to optimise the accuracy of determination of the frequency and/or amplitude of a typical spectral line peak. In the third example, the interpolation means fits the stored values to a Gaussian curve.

In order that the invention may be better understood, one example of apparatus embodying the invention will now be described, with three different interpolation techniques, with reference to the accompanying schematic block diagram.

The spectrum analyzer, of which the relevant parts only are shown diagrammatically, comprises an analogue-to-digital converter 11 for sampling an input signal 10, and a multiplier 12 for applying a stored data window function 13 to the sampled data. The shaped data from the data window are then fed to a fast Fourier transform processor 14 which performs a discrete Fourer transformation and supplies output data to an interpolator 15 having a stored interpolation function 16.

The interpolator 15 interpolates an estimated curve 171 between the three adjacent data points closest to a spectral line peak, i.e. at the frequency bin associated with a data maximum and at its two nearest neighbouring bins. This estimated curve is chosen to be a Gaussian or near-Gaussian, whose peak will be generally much closer to the true peak than is the centre of the middle frequency bin. The interpolated output data are output to a video display 17 and/or to a numerical display 18 indicative of the frequency and/or amplitude of the spectral line peak.

Three examples of the data window and interpolation functions will now be described.

### Example 1

The data window 13 and the interpolation curve 16 are both exact Gaussian curves.

The Gaussian is a curve which can be defined by three variables; amplitude, position and width. This means that it can be specified by just three points, as for the parabolic:

$$y = \exp\ (k\text{-}a^*(x\text{-}c)^2),$$

where:

k controls the amplitude;

c controls the position; and

a controls the width.

This equation for a Gaussian is the exponential of a parabolic. Taking logs yields a parabolic in x, which can be interpolated exactly using second order interpolation. The interpolated result can be exponentiated to give a linear answer, or, more usually, left in log form and read as dB.

If the three amplitude values y are p, g and r, and the corresponding values of frequency are $x = -1$, 0 and 1, then it follows trivially that the peak of the Gaussian curve which passes through the three points is at:

$$x = (p\text{-}r) - 2(p + r - 2q)\ \text{and}$$
$$y = q + (p\text{-}r)^2 - 8(2q\text{-}p\text{-}r).$$

A window which has a transform whose top matches a Gaussian extremely closely is the Gaussian window itself. The actual shape of the spectral peak is a Gaussian convolved with a sinc function. As the cutoff of the time window goes to larger values of sigma, the Gaussian curve dominates the spectral peak more. With a cutoff of 3 sigma, the spectral peak is Gaussian to the 0.001dB level. In addition, the position of the peak can be estimated very accurately.

It should be observed that Gaussian windows are not normally the window of first choice for most applications. They tend to have a wider main lobe for the same sidelobe level than most of the accepted windows such as Kaiser Bessel or Hamming. The main lobe is however considerably narrower than for a flat-top window.

## Example 2

The interpolation curve 16 is chosen to be Gaussian, and the data window 13 is an optimised Blackman-Harris window.

The Blackman-Harris family of windows are each sums of cosines, whose peaks coincide at a common centre. Up to now, these windows have been optimised solely for sidelobe level and mainlobe width. Adding a constraint to the shape of their transform for a width of 3 bins centred on the peak results in data windows with good sidelobe and peak level, and capable of being interpolated to accuracies ranging from 0.03dB to essentially perfect, depending on the weighting given to each parameter. The sidelobe and mainlobe performance degrades as the interpolation accuracy improves, and for a collection of parameters similar to a Gaussian window, the optimised window improves little on the Gaussian. However, for specific applications where the Gaussian does not represent a good compromise, an optimised window can be found to do better than a Gaussian.

## Example 3

The data window 13 is chosen to be a specific Blackman-Harris window, and the interpolation curve 16 is optimised to be a near-Gaussian curve.

A very good window, e.g. Blackman Harris 4 term minimum sidelobe, can already be interpolated by a straight Gaussian to 0.03dB, but it is possible to modify the curve slightly to improve the fit. Looking at the errors generated by the interpolation process, it has been seen that they are all of the same sign. Thus a small change in the constant multiplier for the correction term would at worst halve the peak error, by making the positive and negative peaks equal. In practice, for this window, choosing a multiplier value of 0.12 rather than 0.125 has reduced the peak error from 0.03dB to 0.003dB. Thus for this optimised Gaussian, it is assumed that at a peak:

$$y = q + 0.12(p-r)^2-(2q-p-r),$$

for each particular window, there is a multiplier value which will minimise the peak error.

The algorithm for this modified correction still assumes that the peak value of the curve is at the position it would be were the peak Gaussian in shape. As it is not, the position estimation will show a greater error than for Gaussian topped windows.

However, the peak estimation will still be very much better than for even a large amount of Chirp-Z interpolation.

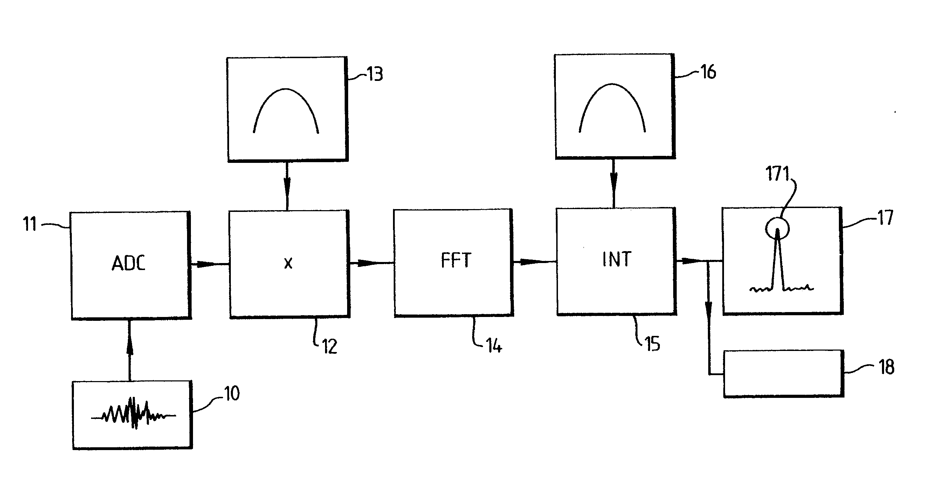

## Claims

1. Apparatus for determining the frequency and/or amplitude of a spectral line in the frequency spectrum of an input signal, comprising a window-defining filter (12, 13) for shaping and truncating the input signal amplitude as a function of time, means (14) for applying a discrete Fourier transform to the filtered input signal to store representations of signal amplitude at each of several predetermined, contiguous frequency bins, and means (15) for interpolating between the stored values of signal amplitude to determine the frequency and/or amplitude of an amplitude peak in the input signal, wherein the interpolation means fits the stored values to a Gaussian or near-Gaussian curve which is close to the Fourier transform of the window function defined by the filter.

2. Apparatus according to Claim 1, wherein the window-defining filter effects a Gaussian shape.

3. Apparatus according to Claim 2, wherein the interpolation means comprises means for fitting the logarithms of the stored values to a parabola, whereby to fit the stored values to a Gaussian curve.

4. Apparatus according to Claim 1, wherein the window-defining filter consists of a Blackman-Harris window.

5. Apparatus according to Claim 4, wherein the interpolation means fits the stored values to a near-Gaussian curve whose parameters are determined such as to optimise the accuracy of determination of the frequency and/or amplitude of a typical spectral line peak.

6. Apparatus according to Claim 4, wherein the interpolation means fits the stored values to a Gaussian curve.

7. Apparatus according to any preceding claim, comprising digital electronic means for sampling the input signal, wherein the window-defining filter and the Fourier transform-applying means comprise data-processing means for shaping the sampled data and for performing the Fourier transform on the shaped data.

8. An electronic spectrum analyser comprising apparatus according to any of Claims 1 to 7, comprising means responsive to the output of the interpolation means to display the frequency spectrum of the input signal.

9. An electronic frequency counter comprising apparatus according to any of Claims 1 to 7, comprising means for displaying the frequency of the spectral line peak.

10. A method of determining the frequency and/or amplitude of a spectral line in the frequency spectrum of an input signal, comprising shaping and truncating the input signal in accordance with a predetermined data window, applying a discrete Fourier transform to the shaped input signal to derive and store representations of signal amplitude at each of several predetermined, contiguous frequency bins, and interpolating between the stored values of signal amplitude to determine the said frequency and/or amplitude, by fitting the stored values to a Gaussian or near-Gaussian curve which is close to the Fourier transform of the data window.